# EUROPÄISCHE PATENTSCHRIFT

(11) **EP 1 661 178 B1**
(45) Veröffentlichungstag und Bekanntmachung des Hinweises auf die Patenterteilung: **06.12.2006**
(21) Anmeldenummer: 04764701.1
(22) Anmeldetag: 01.09.2004
(51) Int. Cl.: H01L 23/049, H01L 23/495

(54) **Elektronisches Bauelement mit Kühlfläche**
Electronic component comprising a cooling surface
Composant électronique comportant une surface de refroidissement

(30) Priorität: 05.09.2003 DE 10341081; 27.01.2004 DE 102004004074
(43) Veröffentlichungstag der Anmeldung: 31.05.2006
(73) Patentinhaber: Rohde & Schwarz GmbH & Co. KG, 81671 München (DE)
(72) Erfinder: FLUHRER, Christoph, 82061 Neuried (DE); SCHNEIDER, Herbert, 81667 München (DE)
(74) Vertreter: Körfer, Thomas
(86) Internationale Anmeldenummer: PCT/EP2004/009740
(87) Internationale Veröffentlichungsnummer: WO 2005/024937

(56) Entgegenhaltungen:
- US-A- 4 436 951
- US-A1- 2002 096 756
- US-A1- 2002 121 684

## Beschreibung

Die Erfindung betrifft ein elektronisches Bauelement zur Montage auf der Oberfläche einer Leiterplatte, insbesondere einen Leistungstransistor für Hochfrequenzanwendungen.

Elektronische Bauelemente, insbesondere Leistungstransistoren, die auf der Oberfläche einer Leiterplatte montiert werden, sind bekannt. Wenn es sich dabei um Bauelemente handelt, welche während des Betriebs gekühlt werden müssen, so ist zusätzlich zu den Kontaktflächen des Bauelements an dem Bauelement eine Befestigungsmöglichkeit vorzusehen, mittels derer ein Kühlkörper an dem Bauelement fixiert werden kann. Ein solches Bauelement ist aus der Patentschrift US-A-4 436 951 bekannt. Aus dem technischen Datenblatt "MRF 1535T1/D", Motorola Inc., 2002, ist z. B. ein Hochfrequenz-Leistungstransistor bekannt, der ein Kunststoffgehäuse aufweist. Aus dem Kunststoffgehäuse sind seitlich Anschlusselemente des Transistors herausgeführt und in Richtung der der Leiterplatte zugewandten Seite des Bauelements umgeformt. An den umgelegten Enden der Anschlusselemente ist jeweils eine Kontaktfläche ausgebildet, so dass das Bauelement auf der Oberfläche einer Leiterplatte fixiert werden kann. Auf der gegenüberliegenden Seite des Bauelements ist eine ebene Fläche vorgesehen, die mit einem Kühlkörper in Anlage gebracht werden kann und auf der der Leiterplatte abgewandten Seite des Bauelements einen Teil des Gehäusses des Bauteils ausbildet. Um den Kühlkörper an dieser Anlagefläche zu fixieren, sind in dem aus Kunststoff gefertigen Gehäuse des Transistors Aussparungen vorgesehen, mittels derer der Transistor und der Kühlkörper gemeinsam auf der Leiterplatte verschraubt werden können.

Insbesondere für Anwendungen im Hochfrequenz-Bereich ist das Umlegen der Anschlusselemente nachteilig. Durch die gekrümmte Geometrie der Anschlusselemente wird eine hohe parasitäre Induktivität und ggf. Auch parasitäre Kapazität erzeugt, die den nutzbaren Frequenzbereich reduzieren. Ferner wird durch die nur geringe Kontaktfläche zwischen dem Kühlkörper und dem Transistor ein spezieller Kühlkörper benötigt, um die im Betrieb eines solchen Leistungstransistors anfallende Wärmemenge zuverlässig ableiten zu können. Dieser spezielle Kühlkörper erfordert darüber hinaus eine unmittelbare Fixierung an dem Gehäuse des Bauelements um einen guten Wärmeübergang sicherzustellen.

Es ist die Aufgabe der Erfindung, ein elektronisches Bauelement zu schaffen, welches eine einfache Montage auf der Oberfläche einer Leiterplatte und eine vereinfachte Anordnung eines Kühlkörpers ermöglicht, wobei das Auftreten einer parasitären Induktivität und/oder Kapazität vermieden wird.

Die Aufgabe wird durch das erfindungsgemäße Bauelement nach Anspruch 1 gelöst.

Bei dem erfindungsgemäßen Bauelement sind die Kontaktflächen so an Anschlusselementen angeordnet, dass das elektronische Bauelement mit den Kontaktflächen auf der Oberfläche einer Leiterplatte befestigt werden kann. Dabei ist ein Anschlusselemente so ausgebildet, dass es auf der der Leiterplatte abgewandten Seite eine zumindest teilweise ebene Kühlfläche ausgebildet hat, welche in Anlage an einen Kühlkörper gebracht werden kann. Dieses Anschlusselemente ist auf der der Leiterplatte zugewandtem Seite so ausgebildet, dass es mindestens einen erhöhten Bereich und mindestens einen vertieften Bereich aufweist. Die Kontaktfläche dieses ersten Anschlusselements ist an einem solchen erhöhten Bereich des Anschlusselements ausgebildet. Das weitere Anschlusselements bzw. die weiteren Anschlusselemente sind in dem oder den vertieften Bereichen des ersten Anschlusselements angeordnet und die jeweilige Kontaktfläche ist daran ausgebildet.

Dadurch, dass die weiteren Anschlusselemente in dem zumindest einen vertieften Bereich des ersten Anschlusselements ausgebildet sind und dass die Kontaktfläche des ersten Anschlusselements in einem erhöhten Bereich des ersten Anschlusselements ausgebildet ist, können die weiteren Anschlusselemente geradlinig in Richtung der Oberfläche der Leiterplatte geführt werden. Damit verkürzt sich nicht nur der gesamte Signalweg von der Kontaktstelle auf der Leiterplatte bis hin zu dem Halbleitersubstrat, das mit Bonddrähten mit den einzelnen Anschlusselementen verbunden ist, sondern es ergibt sich auch eine gegenüber bekannten Bauelementen, die zur Montage auf der Oberfläche einer Leiterplatte vorgesehen sind, verbesserte Geometrie der Anschlusselemente und damit eine Reduzierung der parasitären Induktivitäten und Kapazitäten.

In den Unteransprüchen sind vorteilhafte Weiterbildungen des erfindungsgemäßen elektronischen Bauelements ausgeführt.

Die Anschlusselemente sind innerhalb der Projektion der ebenen Kühlfläche angeordnet. Damit lässt sich ein Kühlkörper, der mit der ebenen Kühlfläche in Anlage ist, auf der Leiterplatte z. B. mittels einer Federspange befestigen, die den Kühlkörper auf das elektronische Bauelement drückt, ohne dass in dem entsprechenden Bereich der Leiterplatte eventuell vorhandene Lötflächen für die Kontaktflächen der Anschlusselemente berücksichtigt werden müssen. Die Lötflächen liegen durch die Anordnung der Anschlusselemente zwangsläufig ebenfalls innerhalb der Projektion der ebenen Kühlfläche auf der Leiterplatte. Zudem ergibt sich durch die Abdeckung sämtlicher Bauteile des Bauelements durch die ebene Kühlfläche, die aus einem metallischen Material gefertigt ist, bereits eine Abschirmung der im Bauelement entstehenden bzw. vorhandenen hochfrequenten Strahlung.

Eine weitere Verbesserung der Abschirmung des Bauelements wird dadurch erreicht, dass der erhöhte Bereich den vertieften Bereich ringsörmig geschlossen umgibt. Die ebene Kühlfläche und der erhöhte Bereich bilden damit eine wannenartige Geometrie aus, in die die übrigen Bauteile des Bauelements eingesetzt werden. Durch das Aufsetzen des gesamten Bauelements auf die Leiterplatte ergibt sich damit eine Kapselung des Bauelements durch das metallisch ausgeführte erste Anschlusselement und damit eine Abschirmung durch das elektronische Bauelement selbst, ohne dass eine zusätzliche Abdeckung erforderlich ist.

Weiterhin ist es vorteilhaft, in dem ersten Anschlusselement mehrere vertiefte Bereiche auszubilden, die beispielsweise durch Ausfräsen eines quaderförmigen Rohlings ausgebildet werden können, wobei in jedem der vertieften Bereiche ein Halbleitersubstrat angeordnet ist und zusätzlich die für jedes Halbleitersubstrat erforderlichen weiteren Anschlusselemente in dem entsprechenden vertieften Bereich ausgebildet sind. Ein auf diese Weise symmetrischer Aufbau, bekannt z.B. als "Push-Pull-" oder "Gegentakt-Aufbau", verbessert das Verhalten des elektronischen Bauelements im Hochfrequenzbereich und reduziert damit den Aufwand, der für ein Anpassnetzwerk erforderlich ist.

Anders als die weiteren Anschlusselemente wird das erste Anschlusselement gemeinsam für sämtliche Halbleitersubstrate des elektronischen Bauelements genutzt, wobei gemäß einer besonders bevorzugten Ausführungsform das erste Anschlusselement ein Source-Anschluss eines Feldeffekttransistors ist. Durch das gemeinsame Nutzen des ersten Anschlusselements als Source-Anschluss für einen Feldeffekttransistor mit mehreren Halbleitersubstraten wird in vorteilhafter Weise vermieden, dass zwischen den jeweiligen Source-Anschlüssen der einzelnen Halbleitersubstrate Potenzialdifferenzen auftreten.

Weiterhin ist es vorteilhaft, die gesamte, von der Leiterplatte abgewandte Oberfläche des elektronischen Bauelements als ebene Kühlfläche auszubilden. Neben der großen Berührungsfläche zwischen dem Kühlkörper und dem elektronischen Bauelement, die den Wärmeübergang begünstigt, wird damit verhindert, dass beim Wärmeübergang zwischen der ebenen Fläche und einem angrenzenden Gehäusebauteil eine Differenz zwischen dem Niveau der ebenen Kühlfläche und dem angrenzenden Gehäusebauteil entsteht, die ein flächiges Aufliegen des Kühlkörpers auf der ebenen Fläche verhindert.

Das erfindungsgemäße elektronische Bauelement ist in der Zeichnung dargestellt und wird in der nachfolgenden Beschreibung näher erläutert. Es zeigen:
- Fig. 1: ein erstes Ausführungsbeispiel für ein erfindungsgemäßes elektronisches Bauelement,
- Fig. 2: eine schematische Darstellung der Anordnung der Kontaktflächen des ersten Ausführungsbeispiels eines elektronischen Bauelements,
- Fig. 3: ein zweites Ausführungsbeispiel für ein erfindungsgemäßes elektronisches Bauelement,
- Fig. 4: eine schematische Darstellung der Anordnung der Kontaktflächen des zweiten Ausführungsbeispiels eines elektronischen Bauelements,
- Fig. 5: ein drittes Ausführungsbeispiel für ein erfindungsgemäßes elektronisches Bauelement,
- Fig. 6: eine schematische Darstellung der Anordnung der Kontaktflächen des dritten Ausführungsbeispiels eines erfindungsgemäßen elektronischen Bauelements und
- Fig. 7: eine beispielhafte Darstellung von auf einer Leiterplatte angeordneten Lötflächen zur Aufnahme des ersten Ausführungsbeispiels des erfindungsgemäßen Bauelements sowie eine beispielhafte Darstellung eines Kühlkörpers.

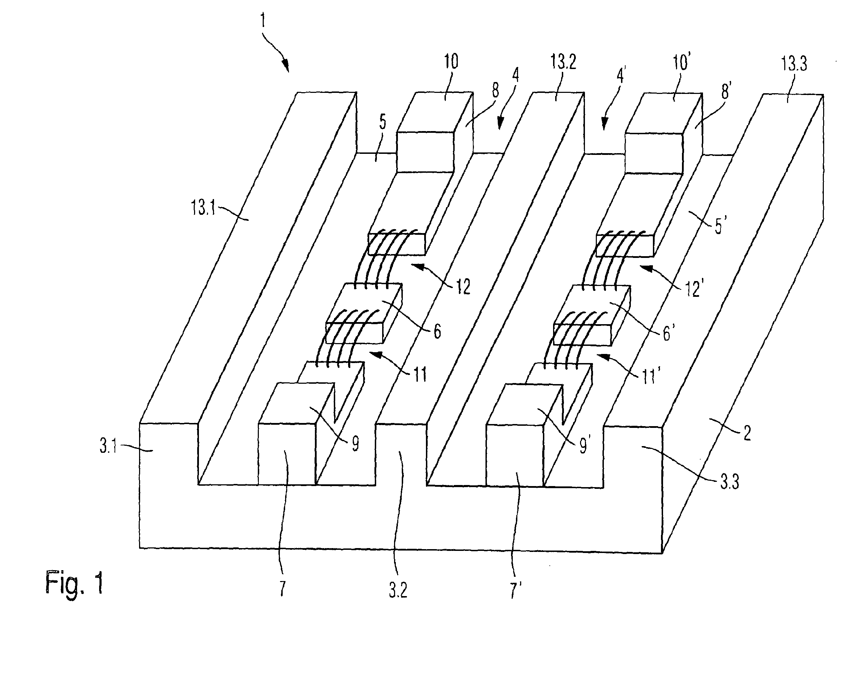

Fig. 1 zeigt ein erstes Ausführungsbeispiel eines erfindungsgemäßen elektronischen Bauelements 1. Ein wesentlicher Teil des Gehäuses des elektronischen Bauelements 1 wird dabei von einem ersten Anschlusselement 2 gebildet. In dem ersten Ausführungsbeispiel ist das erste Anschlusselement 2 mit einer rechteckigen Grundfläche ausgebildet. Parallel zu einer Außenkante der rechteckigen Grundfläche sind an der nach der Montage auf der Leiterplatte angeordneten Seite des elektronischen Bauelements 1 ein erster erhöhter Bereich 3.1, ein zweiter erhöhter Bereich 3.2 und ein dritter erhöhter Bereich 3.3 ausgebildet. Die drei erhöhten Bereiche 3.1, 3.2 und 3.3 sind dabei gleichmäßig über die Grundfläche des ersten Anschlusselements 2 verteilt.

Zwischen den benachbarten erhöhten Bereichen, also zwischen dem ersten erhöhten Bereich 3.1 und dem zweiten erhöhten Bereich 3.2 bzw. dem zweiten erhöhten Bereich 3.2 und dritten erhöhten Bereich 3.3 ist jeweils ein vertiefter Bereich 4 bzw. 4' ausgebildet. Besonders vorteilhaft werden diese vertieften Bereiche 4 und 4' in dem ersten Anschlusselement 2 ausgebildet, indem die beiden vertieften Bereiche 4 und 4' durch Einbringen von parallelen Längsnuten beispielsweise mittels einer Fräse ausgebildet werden.

Im folgenden wird der Einfachheit halber lediglich auf die Anordnung von weiteren Elementen in dem ersten der beiden vertieften Bereiche 4 eingegangen. Die Anordnung in dem zweiten der vertieften Bereiche 4' entspricht der des vertieften Bereichs 4. Sich entsprechende Elemente der beiden Bereiche sind in dem zweiten vertieften Bereich 4' mit gestrichenen Bezugszeichen versehen.

Der vertiefte Bereich 4 erstreckt sich von dem ersten erhöhten Bereich 3.1 bis zu dem zweiten erhöhten Bereich 3.2 und weist eine Grundfläche 5 auf. Auf dieser Grundfläche 5 ist ein Halbleitersubstrat 6 aufgebracht und mit dem ersten Anschlusselement 2 leitend verbunden. Das Halbleitersubstrat 6 kann z. B. ein Transistorelement bzw. eine Gruppe von Transistoren eines Feldeffekttransistors sein, dessen als Source wirkender Bereich mit der Grundfläche 5 leitend verklebt ist. Anstelle des Klebens kann auch eine andere, an sich bekannte Verbindungstechnik eingesetzt werden.

Ebenfalls auf der Grundfläche 5 des vertieften Bereichs 4 ist ein zweites Anschlusselement 7 und ein drittes Anschlusselement 8 angeordnet. Im Gegensatz zu dem Halbleitersubstrat 6 sind diese weiteren Anschlusselemente 7 und 8 jedoch nicht leitend sondern isoliert auf der Grundfläche 5 des vertieften Bereichs 4 des ersten Anschlusselements 2 befestigt. Zur Kontaktierung z.B. des Gate ist das zweite Anschlusselement 7 mittels Bonddrähten 11 mit dem Halbleitersubstrat 6 verbunden. Dementsprechend ist das dritte Anschlusselement 8 ebenfalls mittels Bonddrähten 12 mit dem Drain verbunden.

Das elektronische Bauelement 1 weist an den drei erhöhten Bereichen 3.1, 3.2 und 3.3 jeweils eine Kontaktfläche 13.1, 13.2 und 13.3 auf, welche mit einer korrespondierenden Lötfläche auf der Oberfläche der Leiterplatte verbunden werden. Zudem ist zur elektrischen Kontaktierung des elektronischen Bauelements 1 an dem zweiten Anschlusselement 1 eine zweite Kontaktfläche 9 ausgebildet. An dem dritten Anschlusselement 8 ist eine entsprechende dritte Kontaktfläche 10 ausgebildet, die wie die zweite Kontaktfläche 9 in dieselbe Richtung wie die Kontaktflächen 13.1, 13.2 und 13.3 orientiert ist. Die zweite Kontaktfläche 9 und die dritte Kontaktfläche 10 sind ebenfalls zum Verlöten mit einer korrespondierenden Lötfläche auf der Oberfläche der Leiterplatte vorgesehen.

In dem dargestellten ersten Ausführungsbeispiel sind das zweite Anschlusselement 7 und das dritte Anschlusselement 8 so auf der Grundfläche 5 in dem vertieften Bereich 4 des ersten Anschlusselements 2 angeordnet, dass die zur Außenseite des ersten Anschlusselements 2 orientierte Seite der Anschlusselemente 7 und 8 bündig mit der jeweiligen Seitenfläche des ersten Anschlusselements 2 abschließt. Ebenso ist es denkbar, dass das zweite Anschlusselement 7 und das dritte Anschlusselement 8 ein Stück von der äußeren Begrenzung des ersten Anschlusselements 2 zurückversetzt auf der Grundfläche 5 angeordnet sind.

Die relative Höhendifferenz zwischen den drei erhöhten Bereichen 3.1, 3.2 und 3.3 und den jeweils dazwischen angeordneten vertieften Bereichen 4 und 4' ist so groß gewählt, dass die in einem Bogen verlaufenden Bonddrähte 11 und 12 vollständig innerhalb des vertieften Bereichs 4 verlaufen und damit z. B. durch einen Vergießen des vertieften Bereichs 4 mit einem Kunststoffmaterial geschützt werden können. Im dargestellten Ausführungsbeispiel wird die nötige Höhe für das zweite Anschlusselement 7 und das dritte Anschlusselement 8, die benötigt wird, um die zweite Kontaktfläche 9 und die dritte Kontaktfläche 10 auf dasselbe Niveau wie die Kontaktflächen 13.1, 13.2 und 13.3 zu bringen, dadurch erreicht, dass die beiden Anschlusselemente 7 und 8 eine L-förmige Geometrie aufweisen, deren flacher, auf der Grundfläche 5 angeordneter Bereich über die Bonddrähte 11 und 12 mit dem Gate oder Drain verbunden sind.

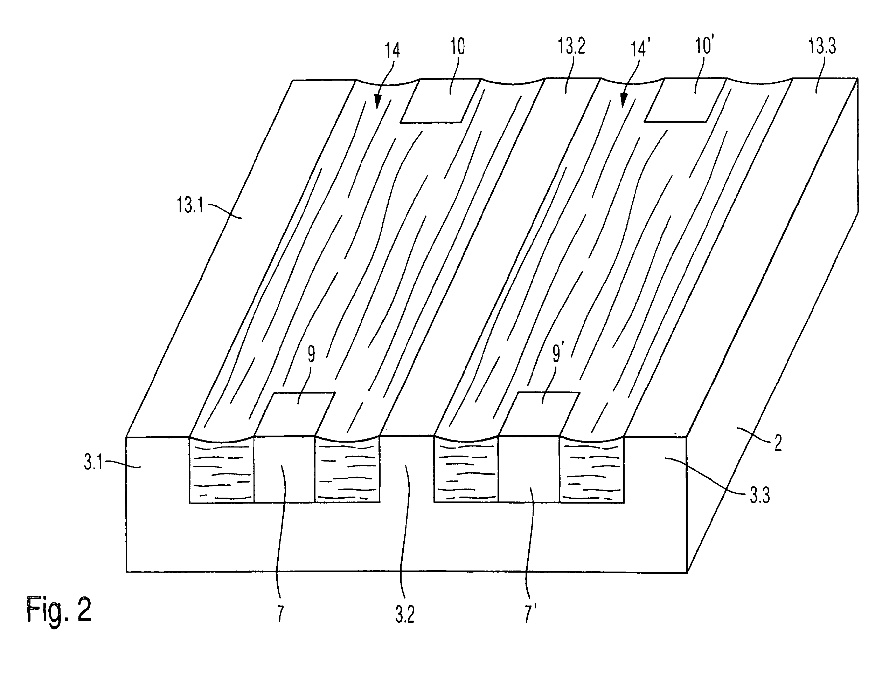

Das Ausführungsbeispiel aus Fig. 1 ist in Fig. 2 noch einmal in einer weiteren perspektivischen Darstellung dargestellt, wobei die vertieften Bereiche 4 und 4' bereits zum Schutz der darin angeordneten Elemente mit beispielsweise einem Kunststoff 14 und 14' ausgegossen sind. Aus der zu der Leiterplatte hin orientierten Oberfläche des Kunststoffs 14 und 14' ragen lediglich die Kontaktflächen 13.1, 13.2 und 13.3 sowie die zweiten Kontaktflächen 9 und 9' und die dritten Kontaktflächen 10 und 10' heraus.

In dem dargestellten Ausführungsbeispiel ist ferner zu erkennen, dass auch die zur Seite zeigenden Begrenzungsflächen der Anschlusselemente 7 und 7' von der Kunststoffumhüllung nicht verdeckt werden. Wie bei der Beschreibung der Fig. 1 bereits erläutert wurde, können die Anschlusselemente 7 und 8 auch in Richtung der Mitte des ersten Anschlusselements 2 versetzt werden, so dass von den zweiten und dritten Anschlusselementen 7 und 8 ausschließlich die jeweiligen Kontaktflächen 9 und 10 durch die Oberfläche der Kunststoffumhüllung ragen.

Anstelle der Nutzung der drei Kontaktflächen 13.1, 13.2 und 13.3 des ersten Anschlusselements 2 kann zur elektrischen Kontaktierung auch beispielsweise lediglich die mittlere Kontaktfläche 13.2 verwendet werden. Die beiden übrigen Kontaktflächen 13.1 und 13.2 des ersten Anschlusselements 2 können dann in einem nicht leitenden Bereich der Oberfläche der Leiterplatte aufgesetzt werden und zum Aufnehmen mechanischer Belastungen dienen, die beispielsweise durch das Anbringen eines Kühlkörpers auf der in der Figur verdeckt liegenden ebenen Kühlfläche entstehen.

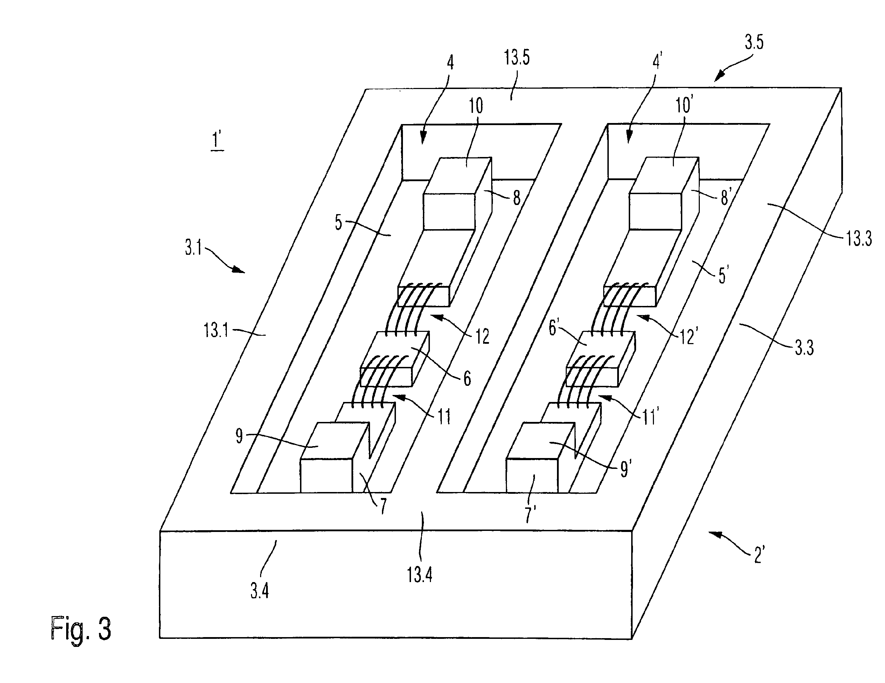

In Fig. 3 ist ein weiteres Ausführungsbeispiel für ein elektronisches Bauelement 1' dargestellt, wobei die mit den Elementen des ersten Ausführungsbeispiels aus Fig. 1 übereinstimmenden Elemente mit identischen Bezugszeichen versehen sind und zur Vermeidung unnötiger Wiederholungen auf eine erneute Beschreibung verzichtet wird.

Im Unterschied zu dem ersten Ausführungsbeispiel sind in der Fig. 3 die vertieften Bereiche 4 und 4' vollständig von erhöhten Bereichen umgeben. Neben den bereits aus der Fig. 1 bekannten erhöhten Bereichen 3.1, 3.2 und 3.3 sind daher weitere erhöhte Bereiche 3.4 und 3.5 vorgesehen, die an gegenüberliegenden Außenseiten des ersten Anschlusselements 2' die erhöhten Bereiche 3.1, 3.2 und 3.3 miteinander verbinden. Durch die erhöhten Bereiche 3.1, 3.2, 3.4 und 3.5 wird damit der vertiefte Bereich 4 vollständig ringförmig umschlossen. Dementsprechend ist durch die erhöhten Bereiche 3.2, 3.3, 3.4 und 3.5. auch der zweite vertiefte Bereich 4' geschlossen umgeben. Damit ist als einzige Seite des elektronischen Bauelements 1' diejenige Seite nicht von einem leitenden Material umhüllt, die der Oberfläche der Leiterplatte zugewandt ist.

Das auf der Leiterplatte montierte elektronische Bauelement 1' benötigt daher keine zusätzliche Abschirmung gegen hochfrequente Einstrahlung, da sämtliche Elemente, insbesondere die Halbleitersubstrate 6 und 6' von dem ersten Anschlusselement 2' umgeben sind.

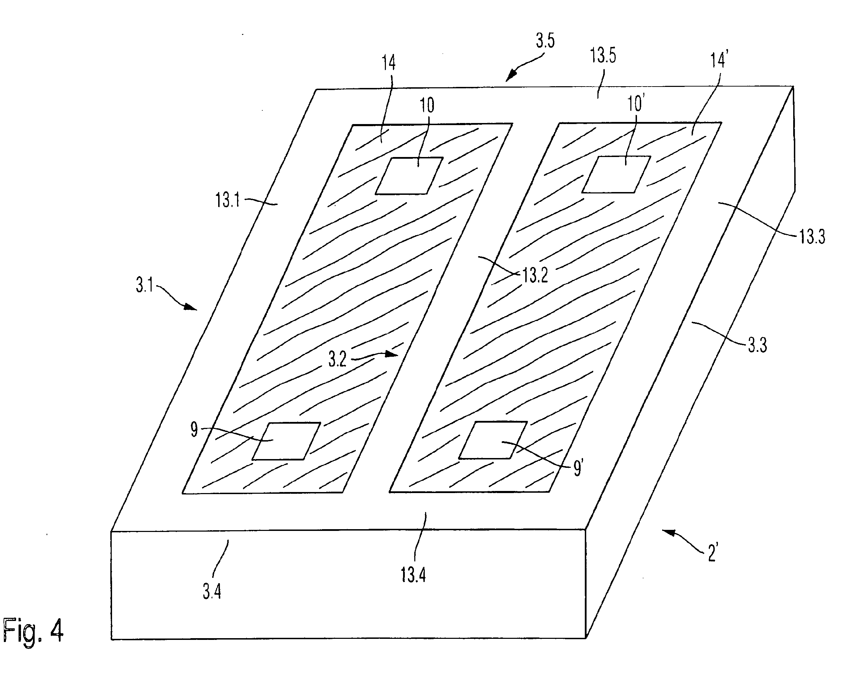

In Fig. 4 ist das elektronische Bauelement 1' aus Fig. 3 noch einmal in einer perspektivischen Darstellung gezeigt, wobei die beiden vertieften Bereiche 4 und 4' erneut vergossen sind. Aus dem zum Vergießen der vertieften Bereiche 4 und 4' verwendeten Material ragen lediglich die Kontaktflächen der erhöhten Bereiche 3.1, 3.2, 3.3, 3.4 und 3.5 sowie die zweiten Kontaktflächen 9 und 9' und dritten Kontaktflächen 10 und 10' heraus, um sie mit entsprechenden Lötflächen auf der Leiterplatte verbinden zu können.

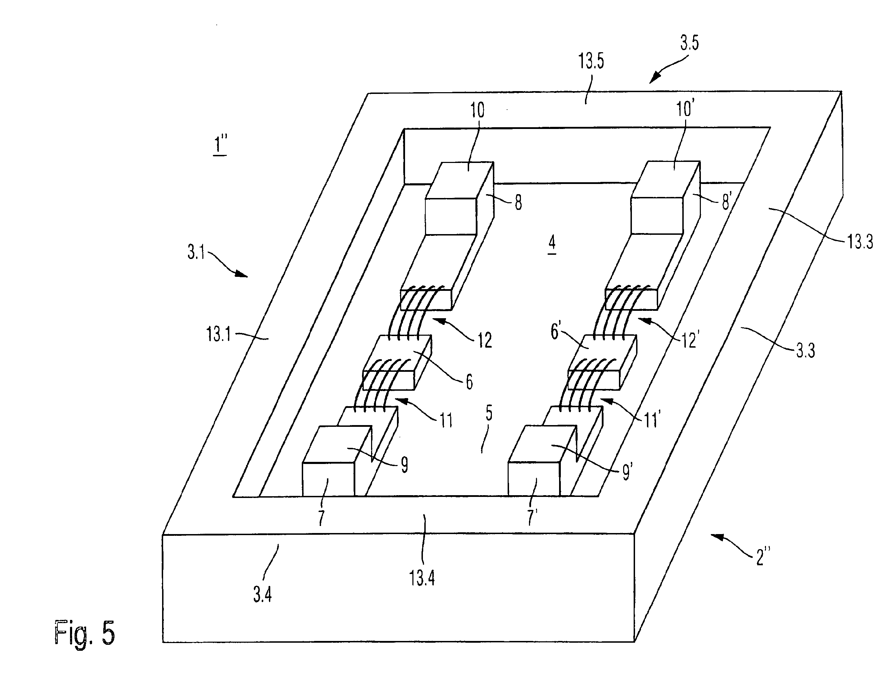

Bei dem dritten Ausführungsbeispiel, wie es in Fig. 5 dargestellt ist, ist der erhöhte Bereich 13.2 nicht vorhanden. Ansonsten entspricht der Aufbau dem zweiten Ausführungsbeispiel. Durch das Entfernen des erhöhten Bereichs 13.2 wird lediglich ein großflächiger, vertiefter Bereich 4 ausgebildet, in dem sowohl das Halbleitersubstrat 6 als auch das weitere Halbleitersubstrat 6' sowie das jeweilige zweite Anschlusselement 7 und 7' und das jeweilige dritte Anschlusselement 8 und 8' gemeinsam angeordnet sind. Der große vertiefte Bereich 4 und die darin angeordneten Elemente werden gemeinsam von den erhöhten Bereichen 3.1, 3.3, 3.4 und 3.5 ringförmig umgeben und damit wiederum gut gegen hochfrequente Einstrahlung geschützt.

Zudem ergibt sich bei der Montage auf der Leiterplatte für alle drei Ausführungsbeispiele eine gute Abstützung des elektronischen Bauelements durch die erhöhten Bereiche auf der Oberfläche der Leiterplatte, so dass ein Kühlkörper, der nicht an dem elektronischen Bauelement selbst, sondern an einer nicht dargestellten Befestigungsvorrichtung auf der Leiterplatte montiert wird, z. B. durch eine Federvorrichtung an die Anlagefläche an dem ersten Anschlusselement angepresst werden kann. Durch das Aufnehmen der Kräfte durch das erste Anschlusselement 2' wird zudem verhindert, dass durch die Kunststoffummantelung Kräfte z. B. bei der Montage des Kühlkörpers aufgenommen werden müssen, die im Extremfall zu einer zerstörenden Belastung für die darin angeordneten Bauelemente werden können.

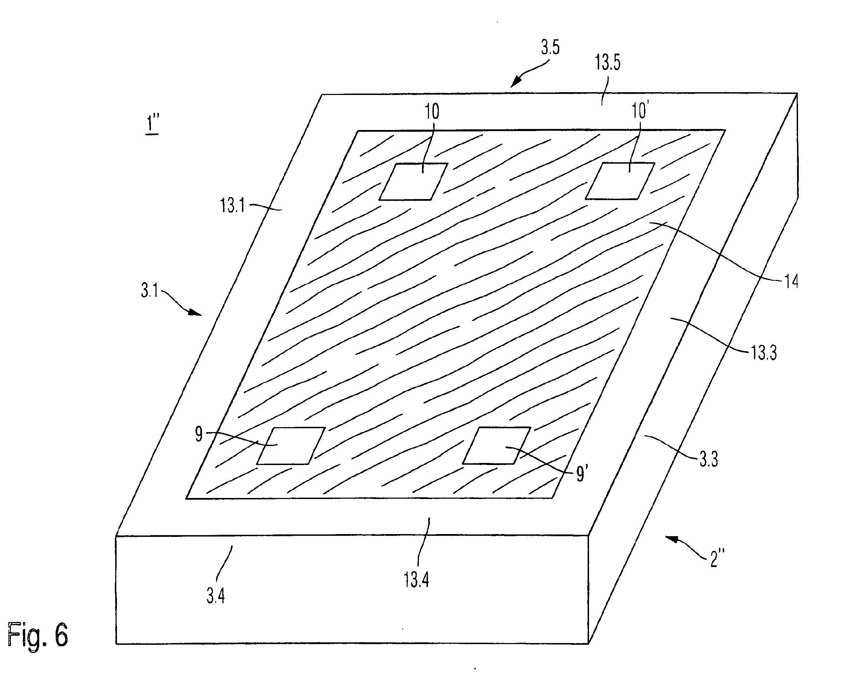

In Fig. 6 sind die wiederum aus einer in dem einzigen vertieften Bereich 4 angeordneten Kunststoffumhüllung herausragenden Kontaktflächen 9, 9', 10, 10' und 13.1, 13.3, 13.4 und 13.5 des elektronischen Bauelements 1'' des dritten Ausführungsbeispiels dargestellt.

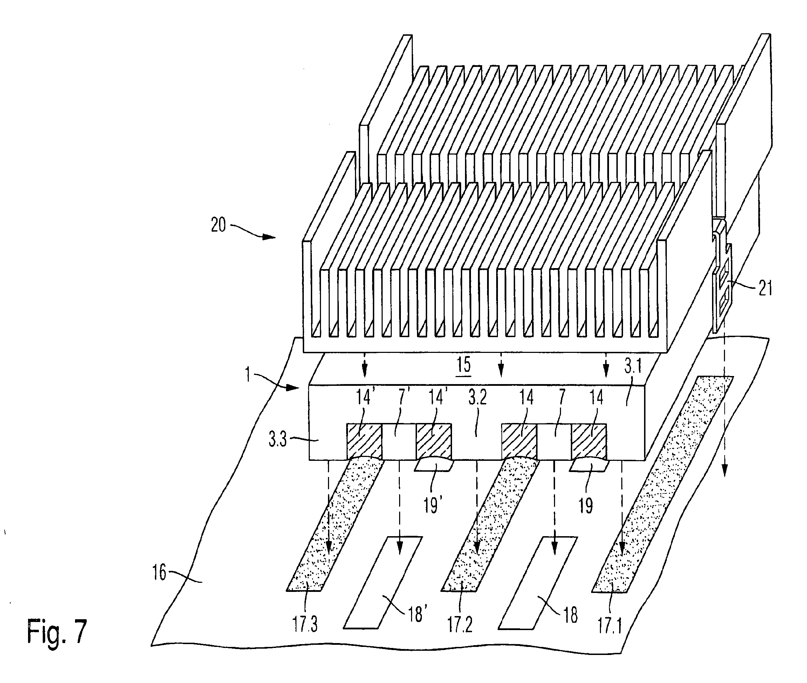

Die Anordnung des erfindungsgemäßen elektronischen Bauelements 1, wie es ausführlich unter Bezugnahme auf die Figuren 1 und 2 erläutert wurde, hinsichtlich der Montage auf einer Leiterplatte 16 ist in Fig. 7 dargestellt. Die Ansicht des elektronischen Bauelements 1 von der Rückseite, also der von der Leiterplatte 16 abgewandten Seite, zeigt eine ebene Kühlfläche 15, die an dem ersten Anschlusselement 2 ausgebildet ist. In dem dargestellten Ausführungsbeispiel ist die ebene Kühlfläche 15 identisch mit den äußeren Abmessungen des gesamten elektronischen Bauelements 1. Damit sind sämtliche weiteren Anschlusselemente 7 bzw. 7' und 8 bzw. 8' innerhalb der Projektion des äußeren Umfangs der ebenen Kühlfläche 15 auf die Oberfläche der Leiterplatte 16 angeordnet. Die gezeigte Ausbildung der ebenen Kühlfläche 15 an dem elektronischen Bauelement 1 entspricht der Ausbildung der ebenen Kühlflächen an den elektronischen Bauelementen 1 und 1'' des zweiten und dritten Ausführungsbeispiels.

Auf der ebenen Kühlfläche 15 kann eine ebenfalls ebene Fläche eines beliebigen, beispielhaft dargestellten Kühlkörpers 20, der für eine Fixierungen auf der Leiterplatte geeignet ist, aufgesetzt werden. Beispielsweise kann ein für Prozessoren von Computern vorgesehener Standard-Kühlkörper 20 auf das elektronische Bauelement 1 aufgesetzt werden und von einer Federklammer 21 in Anlage an der Kühlfläche 15 gehalten werden.

Zum Fixieren des elektronischen Bauelements 1 und zum Kontaktieren der Anschlusselemente des elektronischen Bauelements 1 sind auf der Leiterplatte 16 Lötflächen vorgesehen. Beispielhaft sind in der Fig. 7 erste Lötflächen 17.1, 17.2 und 17.3 gezeigt, auf welchen die Kontaktflächen 13.1, 13.2 und 13.3 der entsprechenden erhöhten Bereiche 3.1, 3.2 und 3.3 des ersten Anschlusselements 2 aufgesetzt werden. Entsprechend sind für die zweiten Anschlusselemente 7 und 7' zweite Lötflächen 18 und 18' vorgesehen. Schließlich sind für die in der Fig. 7 nicht erkennbaren dritten Anschlusselemente 8 und 8' dritte Lötflächen 19 und 19' auf der Oberfläche der Leiterplatte 16 vorgesehen.

Wie bereits bei der Erläuterung der Ausführungsbeispiele des elektronischen Bauelements 1 ausgeführt wurde, muss nicht für jeden erhöhten Bereiche 3.1, 3.2 und 3.3 eine entsprechende Lötfläche 17.1, 17.2 und 17.3 zum Verlöten mit der jeweiligen Kontaktfläche 13.1, 13.2 und 13.3 vorhanden sein. Für eine symmetrische Kontaktierung der jeweiligen Halbleitersubstrate 6 und 6' ist es zum Beispiel ausreichend, wenn lediglich die Lötfläche 17.2 mit der entsprechenden Kontaktfläche 13.2 des erhöhten Bereichs 3.2 des ersten Anschlusselements 2 vorhanden ist.

Das Ausbilden der ebenen Kühlfläche 15 über die gesamte Fläche, die das elektronische Bauelement 1 einnimmt, ermöglicht nicht nur die Verwendung von Standard-Kühlkörpern, sondern stellt auch eine besonders große Kontaktfläche zwischen dem Kühlkörper 20 und dem elektronischen Bauelement 1 sicher. Das Konstruieren und Herstellen von Hochleistungskühlkörpern, die eine besondere, auf die Bauform des Gehäuses eines Hochfrequenztransistors abgestimmte Geometrie aufweisen, ist damit nicht erforderlich. Gegenüber herkömmlichen Transistoren für Hochfrequenzanwendungen hat das erfindungsgemäße Bauelement 1 bzw. 1' oder 1'' zudem den Vorteil, dass ein nur geringfügiger Einfluss der Geometrie der weiteren Anschlusselemente 7, 7' bzw. 8, 8' auftritt, da parasitäre Induktivitäten und Kapazitäten lediglich in geringem Umfang auftreten.

Als solche Standard-Kühlkörper werden insbesondere Kühlkörper von Mikroprozessoren verwendet, die normalerweise in Computersystemen eingesetzt werden. Dort werden sie für die Kühlung der zentralen Recheneinheit, z.B. eines Intel Pentium oder eines AMD Athlon eingesetzt. Typischerweise haben solche Mikroprozessor-Kühlkörper eine quadratische Grundfläche von etwa 80 mm Kantenlänge. Damit überragt ein solcher Kühlkörper die Dimensionen des zu kühlenden Leistungstransistors mit einer typischen rechteckigen Geometrie mit Kantenlängen von 15 mm und 30 mm beträchtlich. Durch die Anordnung auf dem erfindungsgemäßen elektronischen Bauelement 1 ist eine ausreichende Kühlleistung gerade wegen dieser Größe zusammen mit der im Vergleich zum Computersystem höheren Temperaturdifferenz zwischen Bauelement und Umgebung dennoch sichergestellt.

Zur Vermeidung von parasitären Induktivitäten und Kapazitäten trägt insbesondere bei, dass die Anschlusselemente nicht seitlich aus einem Gehäuse herausgeführt werden und dann im Bogen um ein nicht leitendes Kunststoffgehäuse so umgeformt werden, dass die eigentliche Kontaktfläche wiederum innerhalb einer Projektion des Gehäuses des Bauelements auf die Leiterplatte angeordnet ist, so wie dies bei dem Transistor MRF 1535 T1 der Motorol Inc. der Fall ist. Die Anschlusselemente des erfindungsgemäßen Bauelements 1 werden vielmehr weitgehend geradlinig in Richtung der Leiterplatte geführt. Lediglich zum Fixieren der Bonddrähte ist eine geringe Abweichung von der geraden Geometrie erforderlich, so dass die Anschlusselemente eine L-förmige Geometrie aufweisen, deren induktiver Charakter jedoch vernachlässigbar ist.

## Patentansprüche

1. Elektronisches Bauelement mit mindestens zwei Anschlusselementen (2, 2', 2''; 7, 7'; 8, 8'), die jeweils zumindest eine Kontaktfläche (13.1, 13.2, 13.3, 13.4, 13.5; 9, 9'; 10, 10') aufweisen, mit der das elektronische Bauelement (1, 1', 1'') auf einer Oberfläche einer Leiterplatte (16) befestigbar ist, wobei an einem ersten Anschlusselement (2, 2', 2'') eine zumindest teilweise ebene Kühlfläche (15) zur Anlage an einem Kühlkörper (20) ausgebildet ist, die in Richtung der von den Kontaktflächen (13.1, 13.2, 13.3, 13.4, 13.5; 9, 9'; 10, 10') abgewandten Seite des elektronischen Bauelements (1, 1', 1'') orientiert ist,
**dadurch gekennzeichnet,**
**dass** das erste Anschlusselement (2, 2', 2'') auf der der Leiterplatte (16) zugewandten Seite zumindest einen erhöhten Bereich (3.1, 3.2, 3.3, 3.4, 3.5) aufweist, an dem die zumindest eine Kontaktfläche (13.1, 13.2, 13.3, 13.4, 13.5) des ersten Anschlusselements (2, 2', 2'') ausgebildet ist, und zumindest einen vertieften Bereich (4, 4') aufweist, in dem das zumindest eine weitere Anschlusselement (7, 7'; 8, 8') angeordnet ist.

2. Elektronisches Bauelement nach Anspruch 1,
**dadurch gekennzeichnet,**
**dass** die weiteren Anschlusselemente (7, 7'; 8, 8') so angeordnet sind, dass ihre senkrechte Projektion auf die Kühlfläche (15) innerhalb der äußeren Begrenzung der Kühlfläche (15) liegt.

3. Elektronisches Bauelement nach Anspruch 1 oder 2,
**dadurch gekennzeichnet,**
**dass** sich der zumindest eine erhöhte (3.1, 3.2, 3.3, 3.4, 3.5) Bereich im wesentlichen über die gesamte Längsausdehnung des elektronischen Bauelements (1, 1', 1'') erstreckt.

4. Elektronisches Bauelement nach einem der Ansprüche 1 bis 3,
**dadurch gekennzeichnet,**
**dass** der zumindest eine erhöhte Bereich (3.1, 3.2, 3.3, 3.4, 3.5) den zumindest einen vertieften Bereich (4, 4') ringförmig geschlossen umgibt.

5. Elektronisches Bauelement nach einem der Ansprüche 1 bis 4,
**dadurch gekennzeichnet,**
**dass** die Kontaktflächen (13.1, 13.2, 13.3, 13.4, 13.5; 9, 9'; 10, 10') der Anschlusselemente (2, 2', 2''; 7, 7'; 8, 8') als zu der ebenen Kühlfläche (15) planparallele Flächen auf der der Leiterplatte (16) zugewandten Seite des elektronischen Bauelements (1, 1', 1'') ausgebildet sind.

6. Elektronisches Bauelement nach einem der Ansprüche 1 bis 5,
**dadurch gekennzeichnet,**
**dass** die vertieften Bereiche (4, 4') als Ausnehmungen in einem quaderförmigen Anschlusselement (2, 2', 2'') ausgebildet sind.

7. Elektronisches Bauelement nach einem der Ansprüche 1 bis 6,
**dadurch gekennzeichnet,**
**dass** in dem zumindest einen vertieften Bereich (4, 4') zumindest ein Halbleitersubstrat (6, 6') angeordnet ist.

8. Elektronisches Bauelement nach einem der Ansprüche 1 bis 6,
**dadurch gekennzeichnet,**
**dass** mehrere Halbleitersubstrate (6, 6') in dem zumindest einen vertieften Bereich (4) angeordnet sind.

9. Elektronisches Bauelement nach Anspruch 8,
**dadurch gekennzeichnet,**
**dass** mehrere vertiefte Bereiche (4, 4') in dem ersten Anschlusselement (2, 2') ausgebildet sind, in denen jeweils ein Halbleitersubstrat (6, 6') angeordnet ist.

10. Elektronisches Bauelement nach Anspruch 9,
**dadurch gekennzeichnet,**
**dass** für jedes Halbleitersubstrat (6, 6') zumindest ein weiteres Anschlusselement (7, 7', 8, 8') vorgesehen ist, welches in dem jeweiligen, das Halbleitersubstrat (6, 6') aufnehmenden vertieften Bereich (4, 4') angeordnet ist.

11. Elektronisches Bauelement nach Anspruch 10,
**dadurch gekennzeichnet,**
**dass** das erste Anschlusselement (2, 2', 2'') als gemeinsames elektrisches Anschlusselement für sämtliche Halbleitersubstrate (6, 6') des elektronischen Bauelements (1, 1', 1'') vorgesehen ist.

12. Elektronisches Bauelement nach einem der Ansprüche 1 bis 11,
**dadurch gekennzeichnet,**
**dass** das erste Anschlusselement (2, 2', 2'') ein Source-Anschluss eines Feldeffekt-Leistungstransistors ist.

13. Elektronisches Bauelement nach Anspruch 12,
**dadurch gekennzeichnet,**
**dass** die weiteren Anschlusselemente (7, 7'; 8, 8') als Gate-Anschluss und als Drain-Anschluss des Feldeffekt-Leistungstransistors ausgebildet sind.

14. Elektronisches Bauelement nach einem der Ansprüche 1 bis 13,
**dadurch gekennzeichnet,**
**dass** die gesamte von der Leiterplatte (16) abgewandte Kühlfläche (15) als Anlagefläche für einen Kühlkörper (20) ausgebildet ist.

## Claims

1. Electronic component with at least two connecting elements (2, 2', 2''; 7, 7'; 8, 8'), each of which has at least one contact surface (13.1, 13.2, 13.3, 13.4, 13.5; 9, 9'; 10, 10'), with which the electronic component (1, 1', 1'') can be attached to a surface of a printed-circuit board (16), wherein an at least partially flat cooling surface (15), which is orientated in the direction of the side of the electronic component (1, 1', 1'') facing away from the contact surfaces (13.1, 13.2, 13.3, 13.4, 13.5; 9, 9', 9''; 10, 10'), is formed on a first connecting element (2, 2', 2'') for contact with a cooling element (20),
**characterised in that**
the first connecting element (2, 2', 2'') provides at least one raised region (3.1, 3.2, 3.3, 3.4, 3.5) on the side facing towards the printed-circuit board (16), on which the at least one contact surface (13.1, 13.2, 13.3, 13.4, 13.5) of the first connecting element (2, 2', 2'') is formed, and provides at least one recessed region (4, 4'), in which the at least one further connecting element (7, 7'; 8, 8') is arranged.

2. Electronic component according to claim 1,
**characterised in that**
the further connecting elements (7, 7'; 8, 8') are arranged in such a manner that their vertical projection is arranged on the cooling surface (15) within the exterior limit of the cooling surface (15).

3. Electronic component according to claim 1 or 2,
**characterised in that**
the at least one raised region (3.1, 3.2, 3.3, 3.4, 3.5) extends essentially over the entire longitudinal extension of the electronic component (1, 1', 1'').

4. Electronic component according to any one of claims 1 to 3,
**characterised in that**
the at least one raised region (3.1, 3.2, 3.3, 3.4, 3.5) surrounds the at least one recessed region (4, 4') in the form of an enclosed ring.

5. Electronic component according to any one of claims 1 to 4,
**characterised in that**
the contact surfaces (13.1, 13.2, 13.3, 13.4, 13.5; 9, 9', 10, 10') of the connecting elements (2, 2', 2''; 7, 7'; 8, 8') are formed as surfaces plane-parallel to the flat cooling surface (15) on the side of the electronic component (1, 1', 1'') facing towards the printed-circuit board (16).

6. Electronic component according to any one of claims 1 to 5,
**characterised in that**
the recessed regions (4, 4') are formed as recesses in a cuboidal connecting element (2, 2', 2'').

7. Electronic component according to any one of claims 1 to 6,
**characterised in that**
at least one semiconductor substrate (6, 6') is arranged in the at least one recessed region (4, 4').

8. Electronic component according to any one of claims 1 to 6,
**characterised in that**
several semiconductor substrates (6, 6') are arranged in the at least one recessed region (4).

9. Electronic component according to claim 8,
**characterised in that**
several recessed regions (4, 4') are formed in the first connecting element (2, 2'), in each of which one semiconductor substrate (6, 6') is arranged.

10. Electronic component according to claim 9,
**characterised in that**
at least one further connecting element (7, 7'; 8, 8'), which is arranged in the respective recessed region (4, 4') receiving the semiconductor substrate (6, 6'), is provided for each semiconductor substrate (6, 6').

11. Electronic component according to claim 10,
**characterised in that**
the first connecting element (2, 2', 2'') is provided as a common electrical connecting element for all of the semiconductor substrates (6, 6') of the electronic component (1, 1', 1'').

12. Electronic component according to any one of claims 1 to 11,
**characterised in that**
the first connecting element (2, 2', 2'') is a source connection of a field-effect power transistor.

13. Electronic component according to claim 12,
**characterised in that**
the further connecting elements (7', 7', 8, 8') are formed as a gate connection and a drain connection of the field-effect power transistor.

14. Electronic component according to any one of claims 1 to 13,
**characterised in that**
the entire cooling surface (15) facing away from the printed-circuit board (16) is formed as a contact surface for a cooling element (20).

## Revendications

1. Composant électronique avec au moins deux éléments de branchement (2, 2', 2''; 7, 7'; 8, 8') qui comportent chacun au moins une surface de contact (13.1, 13.2, 13.3, 13.4, 13.5; 9, 9'; 10, 10') avec laquelle le composant électronique (1, 1', 1'') peut être fixé sur une surface d'une plaque à circuit imprimé (16), sachant que sur un premier élément de branchement (2, 2', 2''), une surface de refroidissement au moins partiellement plane (15) est configurée pour l'application sur un radiateur (20), laquelle est orientée en direction de la face du composant électronique (1, 1', 1'') détournée des surfaces de contact (13.1, 13.2, 13.3, 13.4, 13.5; 9, 9'; 10, 10'),
**caractérisé en ce que**
le premier élément de branchement (2, 2', 2'') comporte sur la face tournée vers la plaque à circuit imprimé (16) au moins une zone surélevée (3.1, 3.2, 3.3, 3.4, 3,5) sur laquelle est configurée l'au moins une surface de contact (13.1, 13.2, 13.3, 13.4, 13.5) du premier élément de branchement (2, 2', 2''), et comporte au moins une zone surbaissée (4, 4'), dans laquelle est disposé l'au moins un autre élément de branchement (7, 7'; 8, 8').

2. Composant électronique selon la revendication 1,
**caractérisé en ce que**
les autres éléments de branchement (7, 7'; 8, 8') sont disposés de telle sorte que leurs projections orthogonales sur la surface de refroidissement (15) se trouvent à l'intérieur de la limitation extérieure de la surface de refroidissement plane (15).

3. Composant électronique selon la revendication 1 ou 2,
**caractérisé en ce que**
la au moins une zone surélevée (3.1, 3.2, 3.3, 3.4, 3,5) s'étend essentiellement sur l'ensemble de l'extension longitudinale du composant électronique (1, 1', 1'').

4. Composant électronique selon l'une des revendications 1 à 3,
**caractérisé en ce que**
la au moins une zone surélevée (3.1, 3.2, 3.3, 3.4, 3,5) entoure annulairement l'au moins une zone surbaissée (4, 4') en la fermant.

5. Composant électronique selon l'une des revendications 1 à 4,
**caractérisé en ce que**
les surfaces de contact (13.1, 13.2, 13.3, 13.4, 13.5; 9, 9'; 10, 10') des éléments de branchement (2, 2', 2''; 7, 7'; 8, 8') sont configurées comme surfaces planes parallèles à la surface de refroidissement plane (15) sur la face du composant électronique (1, 1', 1'') tournée vers la plaque à circuit imprimé (16).

6. Composant électronique selon l'une des revendications 1 à 5,
**caractérisé en ce que**
les zones surbaissées (4, 4') sont configurées comme évidements dans un élément de branchement (2, 2', 2'') de forme parallélépipédique.

7. Composant électronique selon l'une des revendications 1 à 6,
**caractérisé en ce que**
dans la au moins une zone surbaissée (4, 4') est disposé au moins un substrat de semi-conducteur (6, 6').

8. Composant électronique selon l'une des revendications 1 à 6,
**caractérisé en ce que**
plusieurs substrats de semi-conducteur (6, 6') sont disposés dans la au moins une zone surbaissée (4).

9. Composant électronique selon la revendication 8,
**caractérisé en ce que**
plusieurs zones surbaissées (4, 4') sont configurées dans le premier élément de branchement (2, 2'), dans chacune desquelles est disposé un substrat de semi-conducteur (6, 6').

10. Composant électronique selon la revendication 9,
**caractérisé en ce que**
pour chaque substrat de semi-conducteur (6, 6'), au moins un autre élément de branchement (7, 7'; 8, 8') est prévu, lequel est disposé dans la zone surbaissée (4, 4') respective accueillant le substrat de semi-conducteur (6, 6').

11. Composant électronique selon la revendication 10,
**caractérisé en ce que**
le premier élément de branchement (2, 2', 2'') est prévu comme élément de branchement électrique commun pour tous les substrats de semi-conducteur (6, 6') du composant électronique (1, 1', 1'').

12. Composant électronique selon l'une des revendications 1 à 11,
**caractérisé en ce que**
le premier élément de branchement (2, 2', 2'') est un branchement de source d'un transistor à effet de champ.

13. Composant électronique selon la revendication 12,
**caractérisé en ce que**
les autres éléments de branchement (7, 7'; 8, 8') sont configurés comme branchements de porte et comme branchement de drain du transistor à effet de champ.

14. Composant électronique selon l'une des revendications 1 à 13,
**caractérisé en ce que**
l'ensemble de la surface de refroidissement (15) détournée de la plaque à circuit imprimé (16) est configurée comme surface d'application pour un radiateur (20).
